(19) **Europäisches Patentamt**
**European Patent Office**
**Office européen des brevets**

(11) **EP 3 379 724 A1**

(12) **EUROPEAN PATENT APPLICATION**

(43) Date of publication:
**26.09.2018 Bulletin 2018/39**

(51) Int Cl.:
*H03F 1/52* (2006.01)   *H03F 3/24* (2006.01)
*H04B 1/04* (2006.01)   *H03F 3/193* (2006.01)

(21) Application number: **18172973.2**

(22) Date of filing: **11.05.2015**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Validation States:
**MA**

(30) Priority: **18.09.2014 JP 2014189615**

(62) Document number(s) of the earlier application(s) in
accordance with Art. 76 EPC:
**15841579.4 / 3 197 047**

(71) Applicant: **Panasonic Intellectual Property
Management Co., Ltd.
Osaka-shi, Osaka 540-6207 (JP)**

(72) Inventors:
• OMOTO, Yukihiro
  Osaka, 540-6207 (JP)
• HORIIKE, Yoshio
  Osaka, 540-6207 (JP)
• TERAMOTO, Shota
  Osaka, 540-6207 (JP)

(74) Representative: **Schwabe - Sandmair - Marx
Patentanwälte Rechtsanwalt
Partnerschaft mbB
Joseph-Wild-Straße 20
81829 München (DE)**

Remarks:
This application was filed on 17-05-2018 as a
divisional application to the application mentioned
under INID code 62.

(54) **POWER AMPLIFYING DEVICE**

(57)    A power amplifying device comprising: a power amplifier (4) configured to perform power amplification; and a protection circuit (6); wherein the protection circuit (6) includes a direct-current blocking capacitor (C1) having a first terminal connected to an output of the power amplifier (4); and a diode (D1) having an anode side connected to a second terminal of the direct-current blocking capacitor (C1), and a cathode side connected to a power supply (3) of the power amplifier (4).

FIG. 5

## Description

TECHNICAL FIELD

The present invention relates to a power amplifying device including a transmission amplifier for wirelessly transmitting a high-frequency signal.

BACKGROUND ART

In recent years, a so-called automatic meter reading system that automatically collects meter-reading data of gas or water service via a communication network without using manpower is spreading. For example, an automatic meter reading system that connects a meter installed at each house to an existing public communication network by radio is put to practical use.

Hereinafter, a wireless access point connected to the existing public communication network is referred to as a wireless master unit. Meanwhile, a wireless unit installed in each meter is referred to as a wireless slave unit.

Typically, the wireless master unit of the automatic meter reading system is installed at a utility pole, a rooftop of a building, or the like. Locations of several tens to several hundreds of wireless slave units are within a communication area of one wireless master unit.

In the wireless slave unit of the automatic meter reading system, an antenna and a radio circuit are incorporated in the same housing. Therefore, the wireless slave unit is not installed at each house in a state in which the antenna and the radio circuit are not connected to each other.

However, in a case of the wireless master unit, an antenna and a radio circuit part are separately provided in response to a demand for a freedom of installation. A housing accommodating the radio circuit part is connected to the antenna installed at the utility pole or the rooftop of the building through a coaxial cable.

When the wireless master unit is installed at a site, the coaxial cable is first connected to the housing accommodating the radio circuit part. Then the antenna is connected to a distal end of the coaxial cable. However, there may be cases such as a connection forgetting of the antenna to the distal end of the coaxial cable, and an operation error in which a wireless transmission operation is mistakenly performed when the wireless master unit is installed. When the transmission operation is performed in a state in which the antenna is not connected, a reflected wave reflected at the distal end of the coaxial cable may return to a transmission amplifier of the radio circuit part, resulting in that the transmission amplifier is damaged.

Meanwhile, even when the transmission is performed in the state in which the antenna is not connected, a case in which the transmission amplifier is not damaged may occur. Even in such a case, when the antenna is attached to the coaxial cable while the transmission operation is performed, the transmission amplifier may be damaged at the moment when the antenna is attached.

Then, to prevent the damage to the transmission amplifier of the power amplifying device, the following technique is disclosed. Specifically, a circulator is inserted between the transmission amplifier and the antenna. The reflected wave reflected at an antenna end is then output to a third terminal of the circulator, which is different from a terminal for the transmission amplifier. At this time, when the output of the third terminal is not less than a predetermined level, the operation of the transmission amplifier is stopped (for example, refer to Patent Literature (PTL) 1).

Further, as a similar technique, a power amplifying device configured as follows is disclosed (for example, refer to PTL 2).

Hereinafter, a configuration of a power amplifying device described in PTL 2 will be described with reference to FIG. 7.

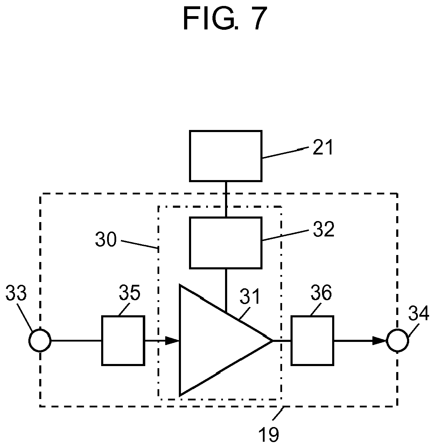

FIG. 7 illustrates a configuration example of a conventional power amplifying device.

As illustrated in FIG. 7, the conventional power amplifying device includes amplifier 19 configuring a transmission amplifier. Amplifier 19 includes transistor 31, overcurrent preventing element 32, signal input terminal 33, signal output terminal 34, input matching circuit 35, and output matching circuit 36. Here, overcurrent preventing element 32 and transistor 31 are mounted on identical semiconductor substrate 30. Further, overcurrent preventing element 32 is made of a low resistance conductor formed of low melting point metal such as tin, lead, or silver. Hence, overcurrent preventing element 32 is heated and fused when a current not less than a predetermined value flows. This configuration shuts off connection between power supply 21 and transistor 31, and prevents damage to transistor 31.

Hereinafter, a specific operation of amplifier 19 in the conventional power amplifying device will be described.

First, a signal input to signal input terminal 33 of amplifier 19 is input to transistor 31 through input matching circuit 35. The input signal is amplified by transistor 31. Amplifier 19 then outputs a predetermined signal from signal output terminal 34 through output matching circuit 36. The signal output from signal output terminal 34 is wirelessly transmitted to the outside through an antenna connected to a coaxial cable. Direct-current power is supplied from power supply 21 to transistor 31 through overcurrent preventing element 32.

At this time, when the antenna is not connected to signal output terminal 34 in amplifier 19, a large current not less than a predetermined current, which is caused by a reflected wave generated at signal output terminal 34, flows through transistor 31. Then, overcurrent preventing element 32 is fused by Joule heat generated by the large current. This stops the supply of the direct-current power from power supply 21 to transistor 31. Thus the damage to transistor 31 is prevented.

However, the configuration of the power amplifying device described in PTL 1 needs the circulator. Therefore, there are problems in view of the number of components, costs, a mounting area, and the like. Further, it is technically difficult to configure an ideal circulator. Hence, the reflected wave may return to a transmission amplifier side depending on a configuration of the circulator. Consequently, there is a possibility that the transmission amplifier is damaged by an influence of the reflected wave, before the operation of the transmission amplifier is stopped.

Further, the configuration of the power amplifying device described in PTL 2 can prevent the damage to transistor 31, which is caused by the over current, by using overcurrent preventing element 32. However, overcurrent preventing element 32 has no effect on damage caused when an overvoltage exceeding a maximum rating voltage of transistor 31 is applied to an output of transistor 31.

Specifically, when the antenna in an unconnected state is then connected, a state of the reflected wave that returns to amplifier 19 is changed. At this time, a high voltage exceeding the rating voltage may be applied to the output of transistor 31. Hence, there is a possibility that transistor 31 is damaged by the high voltage.

Citation List

Patent Literature

PTL 1: Unexamined Japanese Patent Publication No. 2012-239064
PTL 2: Unexamined Japanese Patent Publication No. 2006-157707

SUMMARY OF THE INVENTION

The present invention provides a power amplifying device capable of preventing damage to a transmission amplifier with a simple configuration.

Specifically, the power amplifying device according to the present invention includes a power amplifier that performs power amplification, and a protection circuit. The protection circuit includes a diode having an anode side which receives an output of the power amplifier, a capacitor having one end connected to a cathode of the diode and another end connected to ground or a power supply, and a resistor having one end connected to the cathode of the diode and the other end connected to the ground or the power supply. Further, the protection circuit has a configuration in which a time constant obtained by the capacitor and the resistor is larger than a period of a signal output from the power amplifier.

With this configuration, when a transient high voltage is applied to the output of the power amplifier, the high voltage is absorbed by the capacitor connected to the output of the power amplifier through the diode. This configuration can prevent damage to the power amplifier.

BRIEF DESCRIPTION OF DRAWINGS

FIG. 1 is a configuration diagram of a power amplifying device according to a first exemplary embodiment of the present invention.
FIG. 2 illustrates a first configuration example of a power amplifier of the power amplifying device according to the first exemplary embodiment.
FIG. 3 illustrates a second configuration example of the power amplifier of the power amplifying device according to the first exemplary embodiment.
FIG. 4 illustrates a third configuration example of the power amplifier of the power amplifying device according to the first exemplary embodiment.
FIG. 5 is a configuration diagram of a power amplifying device according to a second exemplary embodiment of the present invention.
FIG. 6 illustrates a configuration example of the power amplifying device according to the second exemplary embodiment.
FIG. 7 illustrates a conventional example.

DESCRIPTION OF EMBODIMENTS

Hereinafter, exemplary embodiments of the present invention will be described with reference to drawings. It is noted that the present invention is not limited to the exemplary embodiments.

FIRST EXEMPLARY EMBODIMENT

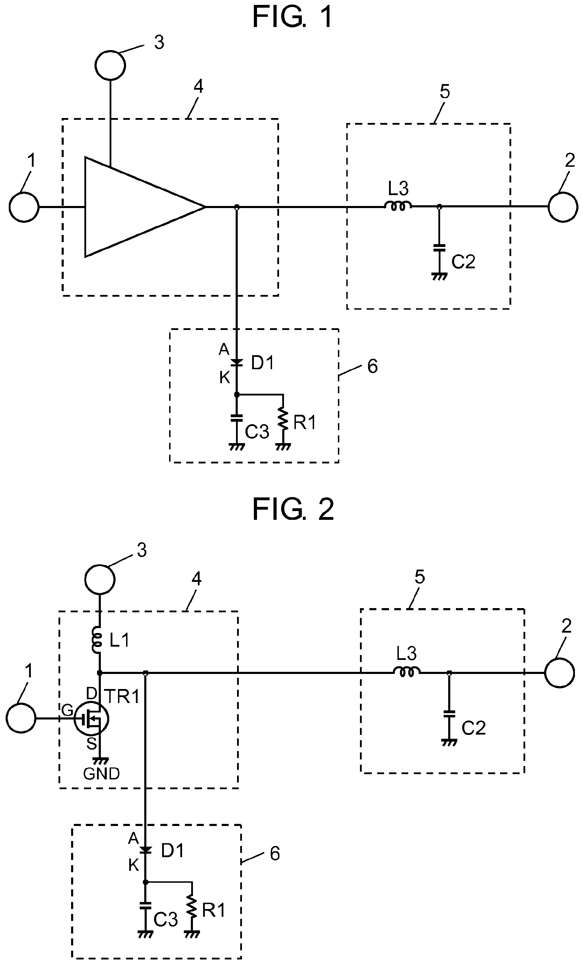

Hereinafter, a configuration of a power amplifying device according to a first exemplary embodiment of the present invention will be described with reference to FIG. 1.

FIG. 1 is a configuration diagram of the power amplifying device according to the first exemplary embodiment of the present invention.

As illustrated in FIG. 1, the power amplifying device according to the present exemplary embodiment is configured with, at least, power amplifier 4, impedance converter 5, voltage absorption part 6, and the like. Voltage absorption part 6 configures a protection circuit.

Further, the power amplifying device amplifies, for example, a high-frequency signal of 169 MHz and outputs the amplified signal. Specifically, power amplifier 4 power-amplifies the high-frequency signal of 169 MHz input from input port 1. The high-frequency signal that is power-amplified is output to output port 2 through impedance converter 5.

Here, the frequency of 169 MHz is an example and is a frequency adopted for transmission and reception between a wireless slave unit and a wireless master unit in, for example, an automatic meter reading system in Europe.

Although not illustrated in FIG. 1, an antenna is connected to output port 2 through a transmission pass or a low pass filter. Typically, when the antenna is connected, load impedance connected to output port 2 is 50 Ω.

Further, a direct-current power supply of voltage Vd is connected to power supply port 3 of power amplifier 4. In the present exemplary embodiment, for example, voltage Vd of 4.5 V is applied to power supply port 3.

Voltage absorption part 6 includes diode D1, capacitor C3, resistor R1, and the like. An output of power amplifier 4 is connected to anode A of diode D1 of voltage absorption part 6, and cathode K of diode D1 is connected to ground (hereafter, simply referred to as "GND") through capacitor C3. Further, resistor R1 of voltage absorption part 6 is connected to capacitor C3 in parallel. It is noted that voltage absorption part 6 is a primary element of the present invention, and configures a protection circuit for absorbing a high voltage.

Impedance converter 5 includes inductor L3 and capacitor C2, and converts the load impedance connected to output port 2 of the power amplifying device. Specifically, impedance converter 5 converts the load impedance of 50 Ω connected to output port 2 of the power amplifying device into 16 Ω for example, and connects the converted load impedance to power amplifier 4. Therefore, when the load impedance of 50 Ω is connected to output port 2 of impedance converter 5, the load impedance connected to the output of power amplifier 4 can be regarded to be 16 Ω. Thus, the load impedance of power amplifier 4 amounts to 16 Ω. Specifically, impedance converter 5 has a function for converting the load impedance including the antenna, which is 50 Ω, into arbitrary load impedance. Further, a transmission output of power amplifier 4 becomes larger, as the load impedance becomes smaller. Hence impedance converter 5 converts the load impedance into a predetermined value to obtain a desired transmission output.

In FIG. 1, as impedance converter 5, the configuration of the low pass filter type configured with inductor L3 and capacitor C2 is described as an example, but the configuration is not limited thereto. For example, a configuration of a high pass filter type in which inductor L3 and capacitor C2 are exchanged may be used.

A power amplifying circuit of the present exemplary embodiment is configured as described above.

Hereinafter, a specific operation of the power amplifying circuit of the present exemplary embodiment will be described.

First, a case in which the antenna is not connected to output port 2 of the power amplifying circuit will be described.

In this case, the high-frequency signal of 169 MHz output from output port 2 of the power amplifying circuit is reflected at an end of the transmission pass to be connected to the antenna. Then a standing wave is generated in the transmission pass. Here, the load impedance connected to the output of power amplifier 4 can take a value ranging from 0 Ω to infinity, depending on a length of the transmission pass.

However, in reality, there are a loss in the transmission pass and a loss in impedance converter 5, and therefore a standing wave ratio (hereafter, referred to as "VSWR") is approximately 10 at maximum. Specifically, assuming that the VSWR is 10, the load impedance of power amplifier 4 can take a value ranging from 1.6 Ω to 160 Ω.

Here, assuming that the load impedance when the antenna is not connected is 1.6 Ω and an output voltage of power amplifier 4 is Va, a current flowing through the load impedance is estimated. Then large current I that amounts to Va/1.6 flows through the load impedance (1.6 Ω).

Subsequently, in the above-described state, a case in which the antenna in an unconnected state is then connected will be described.

When the antenna is connected, the load impedance of power amplifier 4 changes from 1.6 Ω that is the value in the unconnected state of the antenna to 16 Ω, as described above. However, an output current of power amplifier 4 cannot immediately respond to the rapid change in the load impedance. Hence current I of Va/1.6 described above transiently flows through the load impedance having been changed to 16 Ω. Accordingly, at the moment when the antenna is connected, output voltage Vb of power amplifier 4 becomes a value expressed by the following expression.

$$ Vb = (16/1.6) \times Va = 10 \times Va $$

In other words, a voltage that is 10 times as large as voltage Va at normal operation is instantaneously generated in the output of power amplifier 4. Hence, when generated output voltage Vb is not less than a maximum rating voltage of an element configuring power amplifier 4, power amplifier 4 is damaged.

Therefore, the power amplifying device of the present exemplary embodiment suppresses the generation of voltage Vb described above by using voltage absorption part 6, and prevents the damage to power amplifier 4.

Hereinafter, an operation of voltage absorption part 6 will be specifically described.

First, in a state in which the antenna is not connected, when the load impedance of power amplifier 4 is 1.6 Ω, an output signal of power amplifier 4 vibrates with amplitude of voltage Va. The output signal is rectified with diode D1 and capacitor C3 in voltage absorption part 6, and a voltage of cathode K of diode D1 becomes a direct-current voltage. The direct-current voltage becomes (Va - a voltage between anode A and cathode K of the diode).

Here, assuming that Va >> (the voltage between anode A and cathode K of the diode), the voltage of cathode K of diode D1 is substantially equal to voltage Va. Then, hereafter, a description will be made while neglecting (the voltage between anode A and cathode K of the diode).

In the above state, when the load impedance changes from 1.6 Ω to 16 Ω by connecting the antenna, anode A of diode D1 attempts to rise to voltage Vb, in accordance with current I transiently generated in power amplifier 4. However, transiently generated current I flows into GND through capacitor C3 in voltage absorption part 6. Therefore, the voltage of anode A of diode D1 hardly rises from voltage Va at normal operation. In other words, a high voltage is not generated in the output of power amplifier 4. Thus, the damage to power amplifier 4 caused by the high voltage is prevented.

Meanwhile, in a steady state in which the antenna is connected, the output of power amplifier 4 vibrates with the amplitude of voltage Va at normal operation. Here, a time constant obtained by capacitor C3 and resistor R1 of voltage absorption part 6 is set to be an extremely large value in comparison with a period of 169 MHz that is the output signal of power amplifier 4. Hence a current hardly flows through diode D1 of voltage absorption part 6. This allows a voltage of a connecting point between capacitor C3 and diode D1 to maintain direct-current voltage Va. In other word, in the steady state, even when voltage absorption part 6 is inserted in the output of power amplifier 4, an influence such as a reduction in the transmission output is negligible.

It is noted that the time constant obtained by capacitor C3 and resistor R1 of voltage absorption part 6 may be selected so as not to influence a transmission signal with amplitude capable of being demodulated on a reception side.

The power amplifying circuit of the present exemplary embodiment operates as described above. With this operation, the transient high voltage can be absorbed, and thus the damage to power amplifier 4 can be prevented.

Subsequently, a specific configuration of the power amplifier of the power amplifying circuit of the present exemplary embodiment will be described.

First, a first configuration example using a field effect transistor (FET) such as a metal oxide semiconductor field effect transistor (MOSFET) as power amplifier 4 will be described, with reference to FIG. 2.

FIG. 2 illustrates the first configuration example of the power amplifier of the power amplifying device according to the present exemplary embodiment.

As illustrated in FIG. 2, power amplifier 4 of the first configuration example includes transistor TR1 formed of the FET such as the MOSFET, and choke coil L1. As for transistor TR1, gate G is connected to input port 1, source S is connected to GND, and drain D is connected to power supply port 3 through choke coil L1. Transistor TR1 operates as a switch for performing an on/off operation based on the high-frequency signal of 169 MHz input from input port 1 to gate G. In other words, power amplifier 4 forms a saturated operation type amplifier.

First, in a steady state in which the antenna is not connected, a voltage of drain D of transistor TR1 vibrates as a signal of 169 MHz having amplitude Vd centering on direct-current voltage Vd applied to power supply port 3. In other words, the voltage of drain D of transistor TR1 vibrates between 0 V and twice as large as Vd. Then, the voltage of cathode K of diode D1 becomes a direct-current voltage of 2 × Vd.

In this state, when the antenna is connected, the load impedance of power amplifier 4 changes from 1.6 Ω to 16 Ω. At this moment, choke coil L1 attempts to maintain a current flowing through choke coil L1 when the load impedance is 1.6 Ω. Hence, as described in FIG. 1, the voltage of drain D of transistor TR1 attempts to rise. However, since voltage absorption part 6 absorbs the rise in the voltage, the voltage of drain D hardly rises from 2 × Vd. In other words, when transistor TR1 is an element whose maximum rating is larger than 2 × Vd, transistor TR1 is not damaged when the antenna is connected.

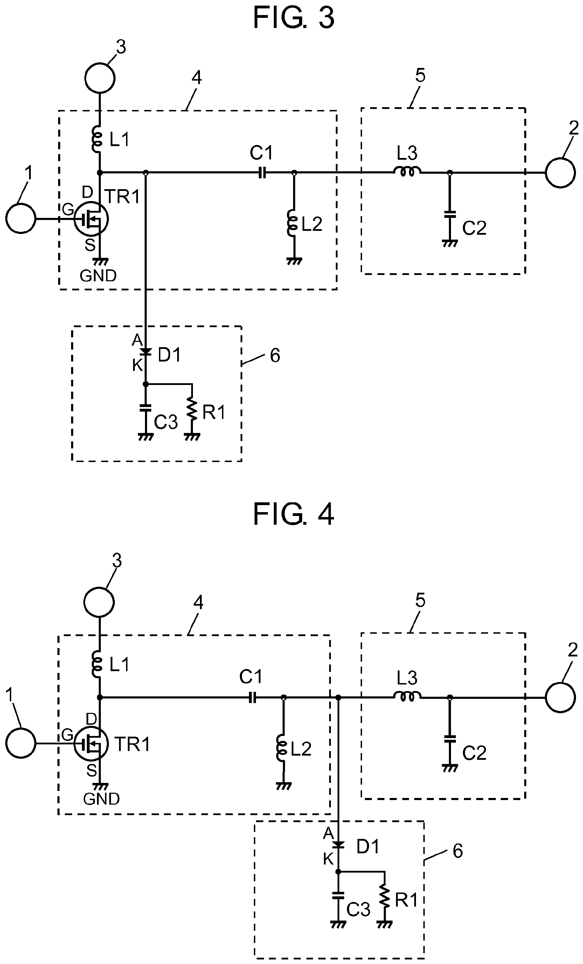

Subsequently, a second configuration example using the FET such as the MOSFET as power amplifier 4 will be described, with reference to FIG. 3.

FIG. 3 illustrates the second configuration example of the power amplifier of the power amplifying device according to the present exemplary embodiment.

It is noted that the second configuration example is different from the power amplifier of the first configuration example in that capacitor C1 and inductor L2 are further added.

Capacitor C1 of the second configuration example operates as a direct-current blocking capacitor. Inductor L2 functions so as to cancel capacitance between drain D and source S, which is present inside transistor TR1. This configuration improves power efficiency of power amplifier 4.

Further, when the load impedance of power amplifier 4 changes from 1.6 Ω to 16 Ω, capacitor C1 and inductor L2 function so as to converge a transient response of the output of transistor TR1 in a vibratory manner. In other words, a rapid voltage fluctuation of drain D of transistor TR1 can be converted to a voltage fluctuation that vibrates gently, in comparison with the power amplifier of the first configuration example illustrated in FIG. 2. This configuration can reduce a burden for absorbing the voltage fluctuation in voltage absorption part 6. Then, the voltage fluctuation can be absorbed more efficiently.

Subsequently, a third configuration example using the FET such as the MOSFET as power amplifier 4 will be described, with reference to FIG. 4.

FIG. 4 illustrates the third configuration example of the power amplifier of the power amplifying device according to the present exemplary embodiment.

It is noted that the third configuration example is different from the second configuration example in that voltage absorption part 6 is connected after a direct-current component is removed through direct-current blocking capacitor C1.

In power amplifier 4 of a third configuration example, anode A of diode D1 vibrates as a signal of 169 MHz having amplitude Vd centering on 0 V in the steady state. Then, the voltage of cathode K of diode D1 becomes a direct-current voltage of Vd. Further, a direct-current voltage between both ends of capacitor C1 is Vd.

In this state, when the antenna is connected, the load impedance of power amplifier 4 changes from 1.6 $\Omega$ to 16 $\Omega$. At this moment, choke coil L1 attempts to maintain a current flowing through choke coil L1 when the load impedance is 1.6 $\Omega$.

Therefore, when transistor TR1 is off, the current flowing through choke coil L1 attempts to flow through the load impedance. At this time, since the load impedance changes 10 times from 1.6 $\Omega$ to 16 $\Omega$, the voltage of drain D of transistor TR1 attempts to rise to a voltage 10 times as large as a voltage in a steady operation.

However, most of the current flowing through choke coil L1 flows through voltage absorption part 6 through capacitor C1. Capacitor C1 is a capacitor having sufficiently large capacitance for blocking a direct current. Therefore, the direct-current voltage between both ends of capacitor C1 hardly changes. In other words, the voltage of drain D of transistor TR1 hardly rises from 2 $\times$ Vd. With this configuration, when transistor TR1 is the element whose maximum rating is larger than 2 $\times$ Vd, transistor TR1 is not damaged when the antenna is connected.

It is noted that the configuration in which the power amplifiers of the second and third configuration examples described in FIGS. 3 and 4 are respectively connected to impedance converter 5 through capacitor C1 is described as an example, but the configuration is not limited thereto. For example, a configuration in which impedance converter 5 is directly connected to drain D of transistor TR1 without interposing capacitor C1 may be used.

SECOND EXEMPLARY EMBODIMENT

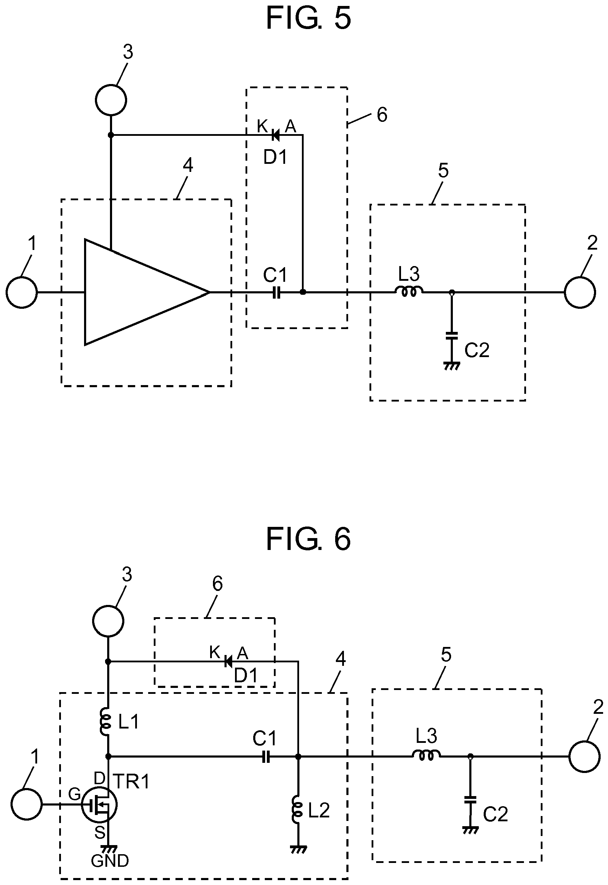

Hereinafter, a configuration of a power amplifying device according to a second exemplary embodiment of the present invention will be described with reference to FIG. 5.

FIG. 5 is a configuration diagram of the power amplifying device according to the second exemplary embodiment of the present invention.

In the power amplifying device of the present exemplary embodiment, a configuration of voltage absorption part 6 is different from that of the first exemplary embodiment. Configurations and operations other than the configuration of voltage absorption part 6 are the same as those of the first exemplary embodiment, and therefore descriptions thereof are omitted.

Specifically, as illustrated in FIG. 5, the power amplifying device according to the present embodiment is configured with, at least, power amplifier 4, impedance converter 5, voltage absorption part 6, and the like. Voltage absorption part 6 configures a protection circuit.

Further, the power amplifying device amplifies, for example, a high-frequency signal of 169 MHz and outputs the amplified signal. Specifically, power amplifier 4 power-amplifies the high-frequency signal of 169 MHz input from input port 1. The high-frequency signal that is power-amplified is output to output port 2 through direct-current blocking capacitor C1 that configures a part of voltage absorption part 6, and impedance converter 5.

Although not illustrated in FIG. 5, an antenna is connected to output port 2 through a transmission pass or a low pass filter. Typically, when the antenna is connected, load impedance connected to output port 2 is 50 $\Omega$.

Further, a direct-current power supply of voltage Vd is connected to power supply port 3 of power amplifier 4. In the present exemplary embodiment, for example, voltage Vd of 4.5 V is applied to power supply port 3.

In FIG. 5, voltage absorption part 6 includes diode D1 and direct-current blocking capacitor C1. At this time, an output of power amplifier 4 is connected to anode A of diode D1 through direct-current blocking capacitor C1, and cathode K of diode D1 is connected to power supply port 3. It is noted that voltage absorption part 6 is a primary element of the present invention, and configures a protection circuit for absorbing a high voltage.

A power amplifying circuit of the present exemplary embodiment is configured as described above.

Hereinafter, a specific operation of the power amplifying circuit of the present exemplary embodiment will be described.

As described in the first exemplary embodiment, when the antenna in an unconnected state is then connected, the load impedance of power amplifier 4 rapidly changes from 1.6 $\Omega$ to 16 $\Omega$. In this case, as described above, voltage Vb that is 10 times as large as voltage Va at normal operation is transiently generated in the output of power amplifier 4.

However, in the present exemplary embodiment, a direct-current component contained in transiently generated voltage Vb is removed by using capacitor C1 at first. After that, transiently generated voltage Vb is absorbed by power supply port 3 through diode D1 of voltage absorption part 6. Therefore, when a voltage between anode A and cathode K of diode D1 is neglected, a voltage of anode A of diode D1 does not rise to not less than voltage Vd of power supply port 3.

In other words, a high-frequency signal of 169 MHz, which vibrates with amplitude of $\pm$Vd at maximum, is transiently generated at anode A of diode D1.

At this time, a maximum voltage applied to the output of power amplifier 4 is (a direct-current bias voltage of the output of power amplifier 4 + voltage Vd of power supply port 3).

Typically, the direct-current bias voltage of the output of power amplifier 4 is lower than voltage Vd of power supply port 3. Therefore, a maximum rating voltage of power amplifier 4 may be set to not less than twice as large as voltage Vd of power supply port 3. With this configuration, even when the load impedance rapidly changes, damage to power amplifier 4 can be prevented.

Subsequently, a configuration example using the MOSFET as the power amplifier of the power amplifying circuit of the present exemplary embodiment will be described, with reference to FIG. 6.

FIG. 6 illustrates a configuration example of the power amplifying device according to the present exemplary embodiment.

As illustrated in FIG. 6, power amplifier 4 of the power amplifying device includes transistor TR1 formed of the MOSFET, and choke coil L1. As for transistor TR1, gate G is connected to input port 1, source S is connected to GND, and drain D is connected to power supply port 3 through choke coil L1.

Further, capacitor C1 of the power amplifying device operates as a direct-current blocking capacitor. Inductor L2 functions so as to cancel capacitance between drain D and source S, which is present inside transistor TR1. This configuration improves power efficiency of power amplifier 4.

In other words, the configuration example of the present exemplary embodiment is different from the first configuration example of the first exemplary embodiment described in FIG. 2 in a configuration and an operation of voltage absorption part 6. Configurations and operations other than the configuration and the operation of voltage absorption part 6 are the same as those of the third configuration example described in FIG. 4 in the first exemplary embodiment, and therefore a description will be made with reference to the third configuration example.

Transistor TR1 operates as a switch for performing an on/off operation based on a high-frequency signal of 169 MHz input from input port 1 to gate G. In other words, power amplifier 4 forms a saturated operation type amplifier.

First, in a steady state in which the antenna is not connected, a voltage of drain D of transistor TR1 vibrates as a signal of 169 MHz having amplitude Vd centering on direct-current voltage Vd applied to power supply port 3. In other words, the voltage of drain D of transistor TR1 vibrates between 0 V and twice as large as Vd. Further, direct-current voltage Vd is removed by direct-current blocking capacitor C1. Therefore, anode A of diode D1 vibrates as a signal of 169 MHz having amplitude Vd centering on 0 V in the steady state. With this configuration, a maximum peak voltage input to anode A of diode D1 becomes Vd. At this time, a voltage of cathode K of diode D1 is voltage Vd of power supply port 3.

Hence a forward current does not flow through diode D1. With this configuration, in the steady state, diose D1 is always in a reverse bias state, which is equivalent to a configuration in which diode D1 is not connected.

In other words, in the steady state, the high-frequency signal of 169 MHz output from power amplifier 4 is output to output port 2 through impedance converter 5, without any influence by inserted diode D1.

Subsequently, in the above state, a transient response caused when the antenna is connected will be described.

In this case, the load impedance of power amplifier 4 changes from 1.6 Ω to 16 Ω. At this moment, as described above, choke coil L1 attempts to maintain a current flowing through choke coil L1 when the load impedance is 1.6 Ω.

Therefore, when transistor TR1 is off, the current flowing through choke coil L1 attempts to flow through the load impedance. At this time, since the load impedance changes 10 times from 1.6 Ω to 16 Ω, the voltage of drain D of transistor TR1 attempts to rise to a voltage 10 times as large as a voltage in a steady operation.

However, most of the current flowing through choke coil L1 flows into power supply port 3 through capacitor C1 and diode D1. Hence the maximum peak voltage of anode A of diode D1 does not become not less than voltage Vd of power supply port 3. Capacitor C1 is a capacitor having sufficiently large capacitance for blocking a direct current. Therefore, a direct-current voltage Vd between both ends of capacitor C1 hardly changes. In other words, the voltage of drain D of transistor TR1 hardly rises from $2 \times$ Vd. With this configuration, when transistor TR1 is the element whose maximum rating is larger than $2 \times$ Vd, transistor TR1 is not damaged when the antenna is connected.

It is noted that, in the configuration example illustrated in FIG. 6 in the present exemplary embodiment, the configuration in which transistor TR1 is connected to impedance converter 5 through capacitor C1 is described as an example, but the configuration is not limited thereto. For example, a configuration in which impedance converter 5 is directly connected to drain D of transistor TR1 without interposing capacitor C1 may be used.

Further, in the above configuration example, the configuration in which transistor TR1 is connected to voltage absorption part 6 through direct-current blocking capacitor C1 is described as an example, but the configuration is not limited thereto. For example, the configuration of voltage absorption part 6 described with reference to FIGS. 2 and 3 may be replaced by voltage absorption part 6 of the present exemplary embodiment. In this case, a terminal through which capacitor C1 and resistor R1 configuring voltage absorption part 6 in FIGS. 2 and 3 are connected to GND is connected to power supply port 3.

Further, in each exemplary embodiment described above, the example in which transistor TR1 is formed of the FET such as the MOSFET is described, but the configuration is not limited thereto. For example, transistor TR1 may be formed of an NPN type bipolar transistor. In this case, base B of the bipolar transistor serves as the input to be connected to input port 1 of power amplifier 4. Meanwhile, collector C of the bipolar transistor serves as the output of power amplifier 4. Furthermore, collector C of the bipolar transistor is connected to power supply port 3 through choke coil L1 of power amplifier 4. With this configuration, actions and effects similar to the FET can be obtained.

As described above, the power amplifying device according to the present invention includes the power amplifier that performs power amplification, and the protection circuit. The protection circuit includes a diode whose anode side receives an output of the power amplifier, a capacitor having one end connected to a cathode of the diode and the other end connected to ground or a power supply, and a resistor having one end connected to the cathode of the diode and the other end connected to the ground or the power supply. Further, the configuration in which the time constant obtained by the capacitor and the resistor is larger than the period of a signal output from the power amplifier may be used.

With this configuration, when the transient high voltage is applied to the output of the power amplifier, the high voltage is absorbed by the capacitor connected to the output of the power amplifier through the diode. This configuration can prevent damage to the power amplifier.

Moreover, the power amplifying device according to the present invention includes the power amplifier that performs power amplification, and the protection circuit. The protection circuit may have the configuration in which one end of the direct-current blocking capacitor is connected to the output of the power amplifier, and the other end of the direct-current blocking capacitor is connected to the power supply of the power amplifier through the diode.

This configuration can prevent the output of the power amplifier from vibrating with amplitude not less than the power supply voltage. This configuration can surely prevent the damage to the power amplifier.

Moreover, the power amplifier of the power amplifying device according to the present invention may be the saturated operation type power amplifier whose transmission output varies depending on the power supply voltage supplied to the power amplifier.

This configuration including the saturated operation type power amplifier is not influenced by a working point of a bias. Therefore, the high voltage that is generated in the output of the power amplifier and is approximately twice as large as the power supply can be absorbed. This configuration can prevent damage to the power amplifier.

Moreover, the power amplifying device according to the present invention may have the configuration in which the power amplifier is formed of the FET which includes the gate as the input and the drain as the output, and further the choke coil is inserted between the drain of the FET and the power supply.

Further, the power amplifying device according to the present invention may have the configuration in which the power amplifier is formed of the transistor which includes the base as the input and the collector as the output, and further the choke coil is inserted between the collector of the transistor and the power supply.

With those simple configurations, the damage to the FET can be prevented.

INDUSTRIAL APPLICABILITY

A power amplifying device according to the present invention can prevent damage to a power amplifier, even when a transmission operation is performed in a state in which an antenna is unconnected to the power amplifier and then the antenna is connected on the midway of the transmission operation. Therefore the power amplifying device according to the present invention is useful for various wireless communication devices. The power amplifying device according to the present invention is particularly useful for a wireless communication device in which an antenna and a wireless communication device body are separately provided and are connected to each other through a coaxial cable.

REFERENCE MARKS IN THE DRAWINGS

    1 input port
    2 output port
    3 power supply port
    4 power amplifier
    5 impedance converter
    6 voltage absorption part (protection circuit)
    19 amplifier
    21 power supply
    30 semiconductor substrate
    31, TR1 transistor
    32 overcurrent preventing element
    33 signal input terminal
    34 signal output terminal
    35 input matching circuit
    36 output matching circuit
    C1, C2, C3 capacitor
    D1 diode
    L1 choke coil
    L2, L3 inductor
    R1 resistor

This invention further relates to the following embodiments which are parts of the description.

Advantageous features of different embodiments can be combined with each other in one embodiment. It is further possible to omit one or more features are not necessary for the specific embodiment.

Preferred embodiments and/or features of the invention are indicated as follows:

Embodiment no. 1.
A power amplifying device comprising:

a power amplifier configured to perform power amplification; and
a protection circuit,
wherein the protection circuit includes
a diode having an anode side which receives an output of the power amplifier,
a capacitor having one end connected to a cathode of the diode and another end connected to ground or a power supply, and
a resistor having one end connected to the cathode of the diode and another end connected to the ground or the power supply, and
wherein a time constant obtained by the capacitor and the resistor is larger than a period of a signal output from the power amplifier.

Embodiment no. 2. A power amplifying device comprising:

a power amplifier configured to perform power amplification; and
a protection circuit,
wherein the protection circuit includes
a direct-current blocking capacitor having a first terminal connected to an output of the power amplifier, and
a diode having an anode side connected to a second terminal of the direct-current blocking capacitor, and a cathode side connected to a power supply of the power amplifier.

Embodiment no. 3. The power amplifying device as indicated in embodiment no. 1 or 2, wherein the power amplifier is formed of a saturated operation type power amplifier whose transmission output varies depending on a power supply voltage supplied to the power amplifier.

Embodiment no. 4. The power amplifying device as indicated in embodiment no. 1 or 2, wherein the power amplifier is formed of an FET which includes a gate as an input and a drain as an output, and a choke coil is inserted between the drain of the FET and the power supply.

Embodiment no. 5. The power amplifying device as indicated in embodiment no. 1 or 2, wherein the power amplifier is formed of a transistor which includes a base as an input and a collector as an output, and a choke coil is inserted between the collector of the transistor and the power supply.

A further preferred embodiment and/or advantageous features of the invention are indicated as follows: A power amplifying device includes power amplifier (4) that performs power amplification, and protection circuit (6). Protection circuit (6) includes a diode having an anode side which receives an output of power amplifier (4), a capacitor having one end connected to a cathode of the diode and the other end connected to ground or power supply (3), and a resistor having one end connected to the cathode of the diode and the other end connected to the ground or power supply (3). Further, protection circuit (6) has a configuration in which a time constant obtained by the capacitor and the resistor is larger than a period of a signal output from power amplifier (4). With this configuration, it is possible to obtain a power amplifying device that can prevent damage to the power amplifier, which is caused by a high voltage generated when an antenna in an unconnected state is then connected, in a transmission state.

**Claims**

1. A power amplifying device comprising:

a power amplifier (4) configured to perform power amplification; and
a protection circuit (6);
wherein the protection circuit (6) includes
a direct-current blocking capacitor (C1) having a first terminal connected to an output of the power amplifier (4); and
a diode (D1) having an anode side connected to a second terminal of the direct-current blocking capacitor (C1), and a cathode side connected to a power supply (3) of the power amplifier (4).

2. The power amplifying device according to claim 1, wherein the power amplifier (4) is formed of a saturated operation type power amplifier whose transmission output varies depending on a power supply voltage supplied to the power amplifier (4).

3. The power amplifying device according to claim 1, wherein
the power amplifier (4) is formed of an FET which includes a gate as an input and a drain as an output, and
a choke coil (L1) is inserted between the drain of the FET and the power supply (3).

4. The power amplifying device according to claim 1, wherein

the power amplifier (4) is formed of a transistor which includes a base as an input and a collector as an output, and
a choke coil is inserted between the collector of the transistor and the power supply (3).

# FIG. 1

# FIG. 2

# FIG. 3

# FIG. 4

## FIG. 5

## FIG. 6

# FIG. 7

Europäisches
Patentamt

European
Patent Office

Office européen
des brevets

# EUROPEAN SEARCH REPORT

Application Number

EP 18 17 2973

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X,P | US 2014/368280 A1 (KNOPIK VINCENT [FR]) 18 December 2014 (2014-12-18) * paragraphs [0001], [0002], [0071] - [0080]; figure 2 * | 1-4 | INV. H03F1/52 H03F3/24 H04B1/04 H03F3/193 |
| X | & EP 2 634 917 A1 (ST ERICSSON SA [CH]) 4 September 2013 (2013-09-04) ----- | 1-4 | |
| X | US 2004/223624 A1 (INAGAKI RYOSUKE [JP]) 11 November 2004 (2004-11-11) * paragraphs [0002], [0008] - [0013], [0016] - [0031]; figure 2 * ----- | 1-4 | |
| X | US 2001/052814 A1 (TAKITA MARK [US]) 20 December 2001 (2001-12-20) * paragraphs [0051], [0052]; figure 5b * ----- | 1-4 | |
| X | US 2012/170773 A1 (MAKABE YOSHIKAZU [JP] ET AL) 5 July 2012 (2012-07-05) * paragraphs [0055] - [0062]; figure 6 * ----- | 1-4 | |

TECHNICAL FIELDS
SEARCHED (IPC)

H03F

The present search report has been drawn up for all claims

| Place of search | Date of completion of the search | Examiner |
|---|---|---|
| The Hague | 11 July 2018 | Goethals, Filip |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

........................................................................

& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 18 17 2973

This annex lists the patent family members relating to the patent documents cited in the above-mentioned European search report.
The members are as contained in the European Patent Office EDP file on
The European Patent Office is in no way liable for these particulars which are merely given for the purpose of information.

11-07-2018

| Patent document cited in search report | | Publication date | Patent family member(s) | | Publication date |
|---|---|---|---|---|---|
| US 2014368280 | A1 | 18-12-2014 | EP | 2634917 A1 | 04-09-2013 |
| | | | US | 2014368280 A1 | 18-12-2014 |
| | | | WO | 2013127663 A1 | 06-09-2013 |
| US 2004223624 | A1 | 11-11-2004 | CN | 1551492 A | 01-12-2004 |
| | | | KR | 20040095662 A | 15-11-2004 |
| | | | TW | 200503412 A | 16-01-2005 |
| | | | US | 2004223624 A1 | 11-11-2004 |
| US 2001052814 | A1 | 20-12-2001 | NONE | | |
| US 2012170773 | A1 | 05-07-2012 | JP | WO2011086617 A1 | 16-05-2013 |
| | | | US | 2012170773 A1 | 05-07-2012 |
| | | | WO | 2011086617 A1 | 21-07-2011 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2012239064 A
- JP 2006157707 A